Europäisches Patentamt

European Patent Office

Office européen des brevets

(11) Publication number: 0 268 386
A2

# EUROPEAN PATENT APPLICATION

(21) Application number: 87309299.3

(22) Date of filing: 21.10.87

(51) Int. Cl.⁴ H01L 29/76 , H01L 29/24

(30) Priority: 18.11.86 US 931844

(43) Date of publication of application:
25.05.88 Bulletin 88/21

(84) Designated Contracting States:
DE FR GB IT NL SE

(71) Applicant: GENERAL MOTORS CORPORATION
General Motors Building 3044 West Grand
Boulevard
Detroit Michigan 48202(US)

(72) Inventor: Partin, Dale L.
37728 Alper
Sterling Heights Michigan 48077(US)
Inventor: Heremans, Joseph P.
2640 Lanergan
Troy Michigan 48084(US)

(74) Representative: Denton, Michael John et al
Patent Section - Luton Office (F6) Vauxhall
Motors Limited P.O. Box 3 Kimpton Road
Luton Bedfordshire LU2 0SY(GB)

(54) Tunnelling transistor.

(57) A tunnelling transistor has an injector layer (32) separated from a channel (28) by a tunnelling barrier (30) of narrow band gap semiconductor material. When biased to threshold with a first voltage, the injector layer injects charge carriers through the tunnelling barrier and into the channel by quantum-mechanical tunnelling. Two spaced-apart contact regions (24,26) disposed on each side of the channel are provided to establish a current which flows between the contact regions through the channel when the channel resistance is lowered by the injection of charge carriers across the tunnelling barrier. By biasing the injector layer with a second voltage, the tunnelling process is reversed, causing charge carriers to tunnel from the channel back through the tunnelling barrier and into the injector layer. The channel current flowing between contact regions is turned off when channel resistance is sufficiently increased. Since tunnelling is inherently a fast process, the transistor has an ultra-fast switching time.

Fig.1

# TUNNELLING TRANSISTOR

The present invention relates generally to current-controlling semiconductor devices and more particularly to semiconductor devices including transistors which provide quantum-mechanical tunnelling of charge carriers through a potential energy barrier.

Various semiconductor switching devices control current by modulating the resistance of a channel region disposed between two regions of semiconductor across which an electrical potential is applied. For example, in metal oxide semiconductor field effect transistors (MOSFETs), channel resistance is capacitively controlled by an insulated gate overlying the channel. The gate bias controls the channel conductance by controlling the carrier density in the channel. Majority charge carriers move in or out of the channel region capacitively under the influence of the gate electric field. MOSFETS however are not injection-based devices.

In other types of semiconductor devices, minority charge carriers are injected across a forward-biased pn junction for current switching and/or amplification. For example, in bipolar junction transistors, a thin layer of semiconductor having a selected conductivity type, either p or n-type semiconductor, is disposed between two layers of semiconductor having the opposite conductivity type, forming, in esssence, back-to-back diodes. In operation, one junction of a bipolar transistor, referred to as the emitter junction, is forward-biased and the other junction, referred to as the collector junction is reverse-biased. Under such biasing, minority carriers are injected from the emitter into the interadjacent or base layer where they diffuse toward the collector junction. The injected minority carriers then move across the collector junction and enter the collector. Through this injection of minority charge carriers, a large current is made to flow across a reverse-biased pn junction.

In another type of known semiconductor device, solid-state tunnelling is the dominant current-producing mechanism. For example, in a pn junction "tunnelling" or "Esaki" diode, the semiconductor material on both sides of a pn junction is ultra-heavily doped so that the conduction band of the n-type material is nearly filled and the valence band of the p-type material is nearly empty. When the diode is properly biased, a "tunnelling" current is produced which is much greater than the diode drift current. In effect, tunnelling charge carriers penetrate the potential energy barrier of the space charge region at the pn junction and travel between valence and conduction bands. An Esaki diode is characterized by a negative resistance for portions of its current voltage profile.

In general, solid-state tunnelling is a quantum-mechanical phenomena by which an electron or hole penetrates an energy barrier of finite height and thickness under the influence of an applied electric field. Transmission through an energy barrier may occur between valence and conduction bands, "interband" tunnelling, as in a pn junction tunnelling diode, or take place "intraband". In intraband tunnelling, transmission occurs between two conduction bands separated by a potential barrier or, alternatively, between two valence bands separated by a potential barrier. Because tunnelling is inherently a very fast process, it is of great interest in semiconductor switching applications.

It is known that quantum-mechanical tunnelling can take place between two semiconductive films separated by an extremely narrow vacuum gap or across a thin-film of barrier material interposed between semiconductive films under an applied voltage. The probability of tunnelling through the barrier, and thus the transmission coefficient for a given materials system, can be determined from a knowledge of the band structure of the materials comprising the device layers. Tunnelling is also known to occur in thin-film heterojunctions formed at the interface of two dissimilar semiconductor materials such as gallium arsenide and germanium.

We have discovered how to design a current-controlling semiconductor device which utilizes the effect of quantum-mechanical tunnelling through a relatively thick tunnelling barrier to rapidly modulate the resistance of a channel region of semiconductor material disposed between two electrical contacts. High current densities through the tunnelling barrier are achieved through the use of narrow band gap semiconductor barrier materials which have small effective carrier masses. Hence, ultra-fast, double-heterojunction switching transistors can be fabricated.

It is a primary object of the present invention to provide a tunnelling transistor for use as a switch or an amplifier which utilizes quantum-mechanical tunnelling to produce ultra-fast switching times.

To this end, a tunnelling transistor in accordance with the present invention is characterised by the features specified in the characterising portion of Claim 1.

The present invention also provides an ultra-fast switching transistor which does not require an atomic-layer thin tunnelling barrier.

The present invention encompasses a novel device for use as a switch or an amplifier which utilizes quantum-mechanical tunnelling through a tunnelling barrier to increase or decreases the charge carrier concentration of a channel disposed between electrical contacts in a semiconductive film.

In one embodiment, the present invention includes a semiconductor film of one material type disposed on an insulative substrate and having first and second spaced-apart, low resistance contact regions formed therein. Positioned between and adjacent to these contact regions is a high resistance channel disposed in the semiconductor film. The channel material may be intrinsic semiconductor or have a conductivity type the same as or different than the contact regions but much more lightly doped than the contact regions. Overlying the channel is an epitaxial layer of tunnel barrier material through which a tunnelling current flows into and out of the channel. The tunnelling barrier comprises a layer of semiconductor material having a band gap higher than that of injector layer material and preferably having a small effective mass for the tunnelling current carrier. The tunnelling barrier is aligned such that it partially overlies each interface of the channel with the corresponding contact region. That is, the tunnelling barrier layer completely covers the channel and extends slightly across each contact, so that the entire channel is injected with carriers which tunnel through the tunnelling barrier.

Disposed over the tunnel barrier layer and in substantial registration therewith is a layer of injector material which serves as a source of mobile charge carriers for injection into the channel. First electrical means, such as metal contacts and electrical leads, is provided to apply an electrical potential across the contact regions of the semiconductor film. Second electrical means is provided for biasing the injector layer with respect to the channel. The tunnelling transistor may be constructed so that the tunnelling current consists of either holes or electrons by choosing appropriate materials and injector voltage polarities. Although designated regions may be doped with impurities to achieve certain characteristics, the present invention is essentially a double heterojunction transistor. For example, a useful device could be constructed on an insulating substrate in a lead-chalcogenide materials system where the channel is undoped or very lightly doped PbTe, the contact regions are n-type PbTe, the injector layer is n-type PbTe and the tunnelling barrier is $Pb_{1-x}Eu_xSe_yTe_{1-y}$. The variables x and y would be adjusted accordingly to obtain optimum lattice matching between the layers and to obtain an energy barrier of appropriate potential energy height for tunnelling carriers.

In an electron device in which the injector band gap is equal to the channel band gap, when the injector layer is biased positively with respect to the channel, little or no current flows between the two contact regions across which a potential is applied. This is because the channel interadjacent the two low resistance contact regions has a very low carrier concentration due to its doping characteristics, eg very lightly p or n-type doping, or, alternatively, due to its low intrinsic carrier concentration as in the case of intrinsic channel material. This is the off state of the tunnelling transistor.

To turn the tunnelling transistor on, the channel resistance must be lowered. In the present invention, this is accomplished by rapidly injecting charge carriers into the channel by quantum-mechanical tunnelling. To do so, the injector layer is biased sufficiently negative with respect to the channel or, depending on the characteristics of the particular materials used in the tunnelling transistor, to approximately the same electrical potential as the channel whereupon electrons in the injector layer tunnel through the tunnelling barrier and into the channel. The injector voltage at which tunnelling occurs is the "tunnelling threshold" for the tunnelling transistor. In the channel, injected carriers move in the direction of the more positive contact region. The injection of carriers into the channel quickly lowers the channel resistance, permitting current to flow between contact regions. This is the on state for the tunnelling transistor characterized by substantial current flow in the channel between the contact regions. When the injector layer is biased such that the product of the voltage and current between contact regions is greater than the product of the voltage and current between the injector layer and the more positively biased contact region, power gain is achieved.

In another embodiment of the present invention, the channel of the tunnelling transistor comprises one or more quantum wells formed by disposing an ultra-thin layer of low band gap semiconductor between the tunnelling barrier and the substrate. By alternating layers of low and high band gap semiconductor in this way, a multiple quantum well structure or "superlattice" can be formed.

The present invention is now described, by way of example, with reference to the following detailed description taken in conjunction with the accompanying drawings, in which:-

Figure 1 is a sectional side view of a tunnelling transistor made in accordance with this invention;

Figure 2 is a graph illustrating the dependence of electron current density on tunnelling barrier thickness;

Figure 3 is a graph illustrating the dependence of hole current density on tunnelling barrier thickness;

Figure 4 is an energy band diagram of the conduction band edge along the line X-X of Figure 1 without injector bias;

Figure 5 is an energy band diagram of the conduction band edge along the line X-X of Figure 1 with injector bias;

Figure 6 is an energy band diagram of the conduction band edge along the line X-X of Figure 1 without injector bias in a tunnelling transistor having a channel band gap higher than the injector band gap;

Figure 7 is an energy band diagram of the conduction band edge along the line X-X of Figure 1 without injector bias in a tunnelling transistor having a channel band gap lower than the injector band gap;

Figure 8 is a graph illustrating the effect of antimony in lowering the heavy valence band of bismuth;

Figure 9 is a sectional side view of a tunnelling transistor made in accordance with the present invention in a BiSb materials system;

Figure 10 is a sectional side view of a tunnelling transistor made in accordance with the present invention in which a buffer layer is interposed between a substrate and a channel;

Figure 11 is an energy band diagram of the conduction band edge along the line Y-Y of Figure 12;

Figure 12 is a sectional side view of a tunnelling transistor made in accordance with the present invention having a quantum well; and

Figure 13 is a sectional side view of a tunnelling transistor made in accordance with the present invention having a superlattice.

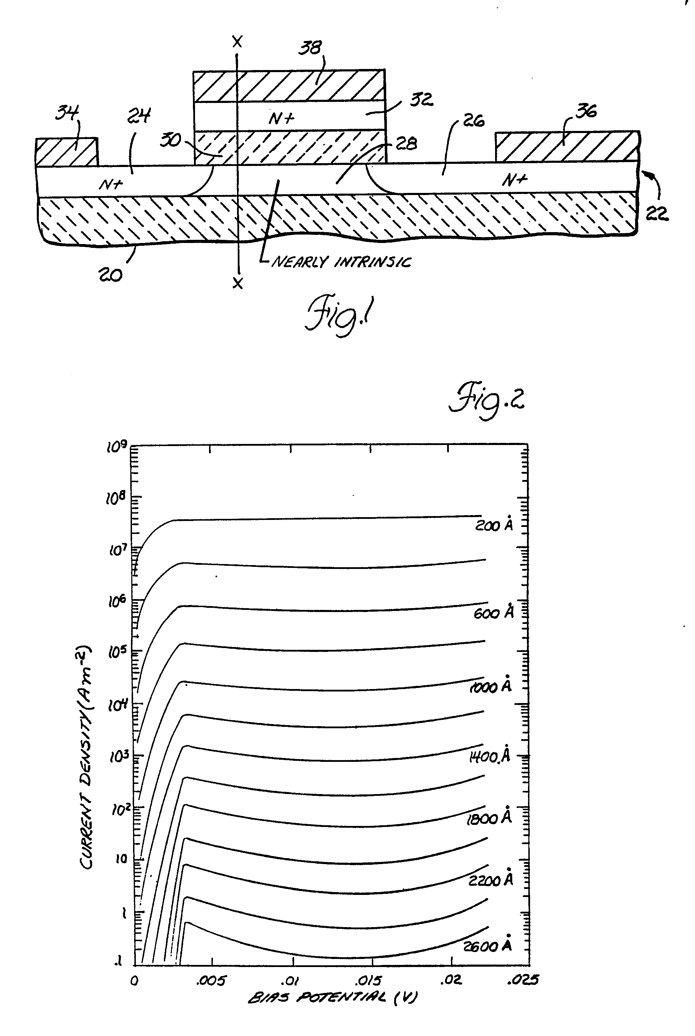

Referring first to Figure 1 of the drawings, a tunnelling transistor in accordance with the present invention is depicted, which includes an insulative substrate 20 having an overlying epitaxial film 22 of intrinsic or nearly intrinsic monocrystalline semiconductor material. It must not be more than lightly doped to p-type or n-type conductivity. Disposed in epitaxial film 22 are first and second spaced apart semiconductor regions or contact regions 24 and 26 respectively. These contact regions 24, 26 correspond to a source and a drain in a conventional insulated gate field effect transistor. Interposed between the first contact region 24 and the second contact region 26 and formed in epitaxial film 22 is a third semiconductor region or channel 28. In this embodiment of our invention, contact regions 24 and 26 are preferably heavily doped to provide low resistance electrical contact, for example, heavily n-type in a tunnelling transistor in which electrons are to be the majority charge carriers in the channel region 28. If holes were to be the majority charge carriers, contact regions 24 and 26 should be doped to p-type conductivity. Contact regions 24 and 26 are at least moderately doped (ie, at least $1 \times 10^{18}$ dopant atoms per cubic centimeter of semiconductive material). The thickness of contact regions 24 and 26 is not critical to the operation of the tunnelling transistor and they can be formed using conventional implant or diffusion techniques. Depending on the type of semiconductor material used and the tunnelling threshold desired, the thickness of channel 28 can vary from about a hundred to several thousand angstroms. As will be explained more fully hereinbelow, channels of a few hundred angstroms in thickness exhibit quantum size effects and are used to form one or more quantum wells.

The composition of insulative substrate 20 should be such that an approximate crystal lattice match is achieved with epitaxial film 22 and it must be an insulating, high band gap material. By selecting an insulating material for insulative substrate 20 which approximates the lattice constant of epitaxial film 22, lattice defects at the interface therebetween which may interfere with conduction between contact regions 24 and 26 through channel 28 can be minimized. Ideally, for a given materials system, insulative substrate 20 should readily promote the growth of adjacent layers, have a similar lattice constant and have a similar coefficient of thermal expansion.

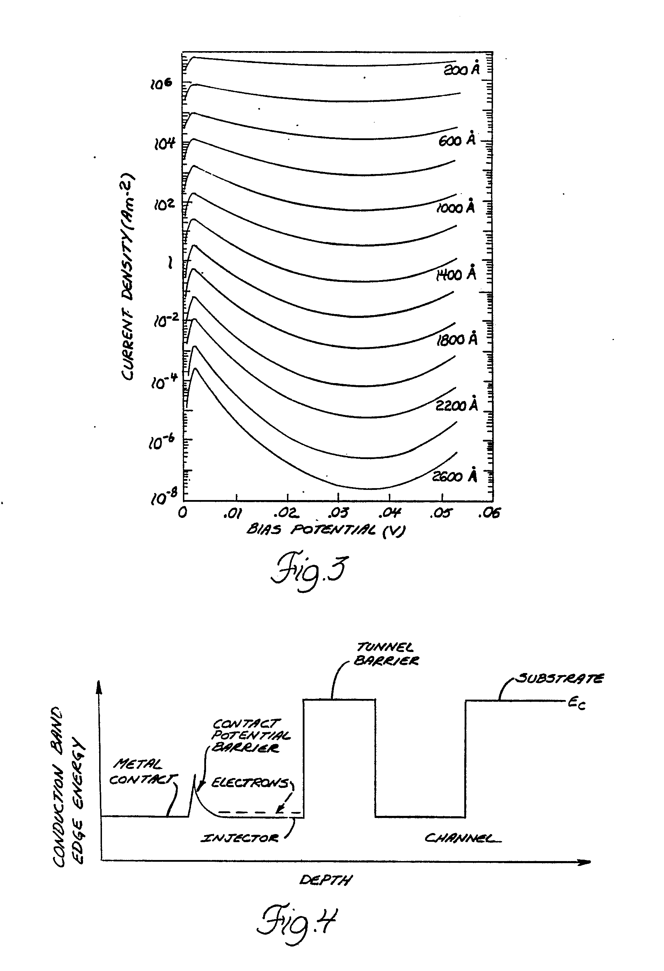

Disposed on epitaxial film 22 is an epitaxial layer of high electrical resistivity (nearly intrinsic) semiconductor material which forms tunnelling barrier 30. It is like an electrically insulating layer. Tunnelling barrier 30 extends across channel 28 and partially over contact regions 24 and 26. In registration with tunnelling barrier 30 and disposed thereon is an injector layer 32 which serves as the source of charge carriers which are injected into the channel 28 during operation of the tunnelling transistor in the on-state. Since injector layer 32 is the source of the majority charge carriers for channel 28, it must be at least moderately doped and preferably heavily doped, to the same type of conductivity as the contact regions 24 and 26. If contact regions 24 and 26 are n-type, injector layer 32 might even be a metal. The thickness of injector layer 32 is not critical and can range from about 100 angstroms to 10,000 angstroms. Accordingly, injector layer 32 can be a metal, a semi-metal or a moderately to heavily-doped semiconductor material and provides charge carriers for the tunnelling process. The lattice constant of injector layer 32 should be tailored to approximately match that of tunnelling barrier 30 which, as stated, should approximately match the lattice constant of channel 28, although substantial latitude in this regard is afforded by "lattice strain". A large number of discontinuities at the heterojunctions of these layers may impede or "short cut" the flow of tunnelling current in the tunnelling transistor. The thickness of tunnelling barrier 30 determines in part the density of the tunnelling current through tunnelling barrier 30 and thus affects the speed with which channel resistance can be changed. As shown in Figure 2 of the drawings which illustrates the dependence of electron current density on barrier thickness, for an injector bias of between 0 and 0.005 volts, in a materials system in which a layer of $Pb_{.78}Sn_{.22}Te$ serves as injector layer 32 and a layer of $Pb_{.70}Sn_{.30}Te$ serves as tunnelling barrier 30, current density increases approximately an order of magnitude for each 200 angstrom decrease in the tunnelling barrier thickness. It is preferred that tunnelling barrier 30 be approximately 200 angstroms to 800 angstroms thick. The use of a relatively thick tunnelling barrier decreases the injector-to-source or drain capacitance, which in turn improves the switching speed of the tunnelling transistor. A similar relationship is shown in Figure 3 for holes tunnelling from an injector layer 32 of $Pb_{.78} Sn_{.22}Te$ through a tunnelling barrier 30 of $Pb_{.70} Sn_{.30}Te$. In another embodiment of our invention which will be discussed below, a thinner tunnelling barrier is used to attain quantum size effects known as "resonant tunnelling".

Metal contacts 34 and 36 (first contact means) shown in Figure 1 can be deposited on contact regions 24 and 26 respectively so that contact can be made thereto by electrical means for applying a potential across contact regions 24 and 26. Similarly, a metal contact 38 can be formed on injector layer 32 so that another electrical means can be used to apply a voltage to bias injector layer 32. It is to be recognized, of course, that the tunnelling transistor could be packaged using conventional thick film techniques or the like.

In operation, injector layer 32 is biased by a voltage applied to metal contact 38 (second contact means) to produce a tunnelling current through tunnelling barrier 30. Charge carriers are injected into channel 28 to turn the tunnelling transistor on and are moved or "injected" out of channel 28 to turn the tunnelling transistor off. In the tunnelling process, tunnelling barrier 30 provides a potential energy barrier having a thickness a and a height $V_o$ through which tunnelling occurs. By biasing injector layer 32, applied electrical field E is generated in the tunnelling barrier 30. Majority charge carriers under the influence of an applied electrical field E tunnel through a potential energy barrier of height $V_o$ where $0<E<V_o$. The composition of tunnelling barrier 30 results in an effective mass $m^*$ for charge carriers as they pass through tunnelling barrier 30. By determining the propagation number $\alpha$ in tunnelling barrier 30,

$$\alpha = \frac{1}{h} [2 m^* (E - V_o)]^{1/2}$$

where h is Planck's constant, the transmission coefficient t can be determined by the following equation:

$$t = \left[ 1 + \frac{V_o^2 \sinh^2 (\alpha a)}{4 E (V_o - E)} \right]^{-1}$$

In determining both the propagation number and the transmission coefficient, the zero for energies and potentials is defined at the band edge. Since the transmission coefficient is the tunnelling probability, multiplying by the number of charge carriers available in injector layer 32 gives the tunnelling current density as plotted in Figures 2 and 3 of the drawings. For a constant applied electrical field E in a specified materials system, tunnelling transmission increases as the effective mass of carriers in tunnelling barrier 30 decreases. This is true since the de Broglie wavelength associated with a carrier increases as effective mass decreases. Therefore, it is preferred to use a barrier material having a small effective mass such as $0.02 \ m_o$, where $m_o$ is the free electron mass.

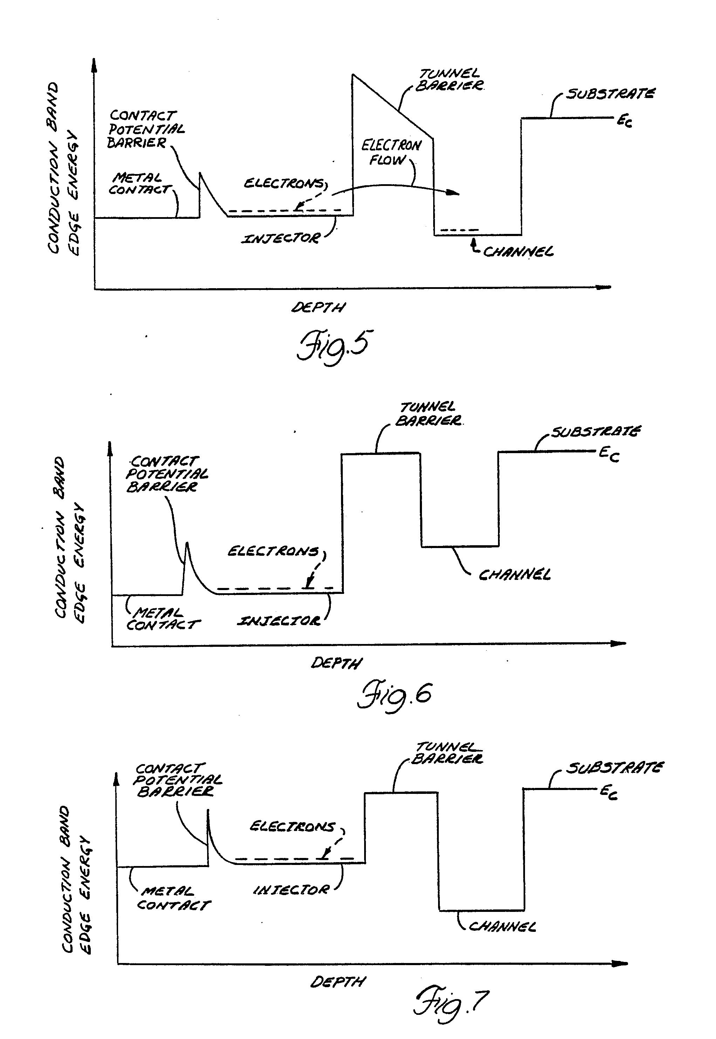

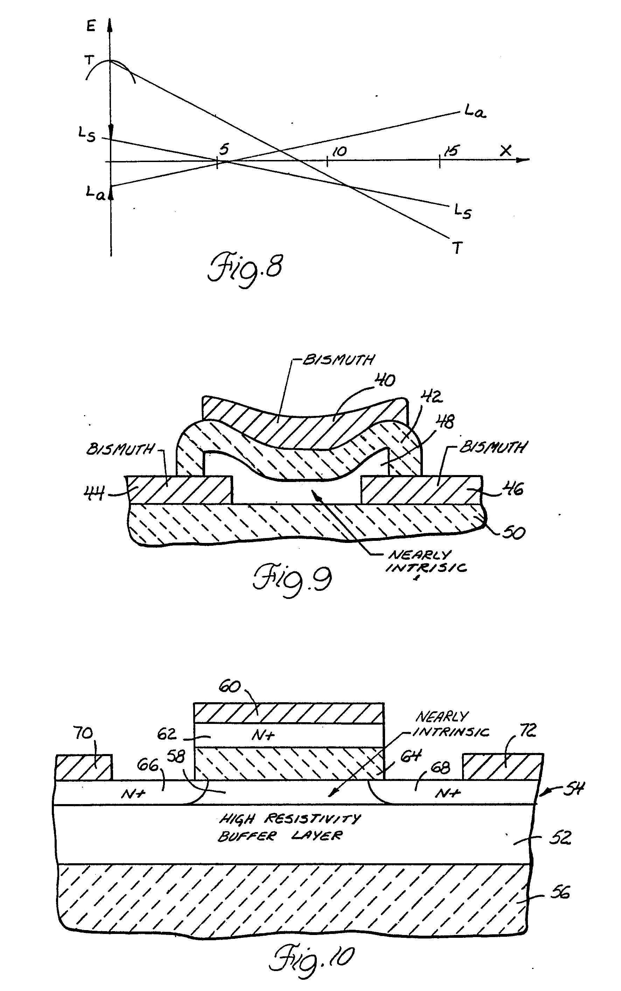

Figure 4 illustrates the band energies of the tunnelling transistor shown in Figure 1 without bias along the line X-X in Figure 1 where channel 28 and injector layer 32 are composed of materials having identical band gaps. Only the conduction band edge is shown for simplicity. In Figure 5, the energy band diagram of Figure 4 is seen with the injector layer 32 biased to the tunnelling threshold. Charge carriers in injector layer 32, here electrons, tunnel through tunnelling barrier 30 into channel 28 under the influence of an applied field. The barrier height is skewed by the applied field. As shown in Figures 6 and 7 of the drawings, the relative positions of the energy bands of injector layer 32, tunnelling barrier 30, and channel 28 can be changed by selecting semiconductor materials having the desired relative band gaps. By changing the band configuration of the tunnelling transistor, the tunnelling threshold can be predetermined for a given application. For example, in Figure 6, channel 28 is at a higher energy without bias than injector layer 32 and thus the tunnelling transistor has a higher tunnelling threshold voltage. In Figure 7, injector layer 32 is at a higher energy without bias than channel 28. This would be the case with a "normally on" tunnelling transistor in which channel 28 has low electrical resistance at zero applied injector voltage.

A wide range of semiconductor materials are suitable for use in forming tunnelling barrier 30. Suitable materials have a band gap larger than the materials used to form injector layer 32 and channel 28 and are preferably narrow gap semiconductors which have a small conductivity effective mass. Such materials include certain lead-chalcogenide or "lead-salt" alloys. These materials can provide effective hole or electron masses as small as 0.01-0.05 $m_o$. These materials are semiconductors and they include such alloys as $Pb_{1-x}Sn_xTe$, $Pb_{1-x}Sn_xSe$, $PbS_{1-x}Se_y$ and $Pb_{1-x}Ge_xTe$. Alloys of PbTe or PbSe with rare earth elements such as Eu and Yb or alkaline earth elements such as Ca and Sr may be suitable. A tunnelling barrier 30 could, for example, be fabricated using $Pb_{1-x}Eu_xSe_yTe_{1-y}$, a high band gap material with a small effective mass, with an injector layer 32 and channel 28 of PbTe, which has a relatively low energy gap. The variables x and y can be adjusted to obtain closely matching lattice constants between the layers, although as stated a working device could be fabricated having significant lattice strain. A tunnelling barrier 30 of $(Pb_{1-z}Sn_z)_{1-x}Eu_xSe_yTe_{1-y}$ would also be suitable if lattice matched to an injector layer 32 and a channel 28 of $Pb_{1-z}Sn_zTe$. It is also desirable that tunnelling barrier 30 have a low carrier concentration, preferably less than $10^{16}$ atoms per cubic centimeter, in the absence of tunnel current.

Many combinations of lead-salt alloy materials for injector layer 32, tunnelling barrier 30 and channel 28 would be suitable for use in the present invention. The material comprising tunnelling barrier 30 would have the highest energy band gap. In the lead-salt system, for example, tunnelling barrier 30 would contain more of at least one of the following elements: Eu, Yb, Ca, Cd, Ge, or Sr, than injector layer 32 or channel 28. The addition of Eu, Yb, Ca, Cd, Ge, S and Sr to PbTe and PbSe increases their energy band gap.

For example, PbTe has an energy gap of 0.2 electron volts. By substituting Eu atoms for some of the Pb atoms in the PbTe crystalline lattice, the energy band gap of the material can be raised significantly. The resulting compound, $Pb_{1-x}Eu_xTe$, has a larger lattice constant than PbTe. By adding Se to the $Pb_{1-x}Eu_xTe$, the lattice constant of the barrier alloy, which is then $Pb_{1-x}Eu_xTe_{1-y}Se_y$, can be reduced back to approximately that of PbTe. The addition of Eu or Sr which raise the energy gap also increase the lattice constant of the material. The addition of Se, S, or Ge is used to correct the lattice constant. The addition of small ( <10%) concentrations of Yb and Ca increases the energy band gap with negligible change of lattice constant. Pure CdTe, or a CdTe/PbTe superlattice could be used for the tunnelling barrier 30 or for the insulative substrate 20. Again, it is preferable to match the lattices of injector layer 32, tunnelling barrier 30, channel 28, and insulative substrate 20 to the extent possible. However, once again it should be noted that since tunnelling barrier 30 is relatively thin, mismatched lattices are acceptable. Lattice mismatch does, however, produce lattice strain which may provide dislocations that may negatively affect carrier mobility by decreasing the mean-free time between scattering events.

For the lead-salt alloys, it is preferred to use, for example, $Pb_{1-x}Eu_xSe_yTe_{1-y}$ where x is approximately 0.05 to 0.3 and y is from about 0.05 to about 0.3. That is, a preferred lead-salt alloy for use herein contains from about 5 to about 30 atomic percent Eu and from about 5 to about 30 atomic percent Se. For $Pb_{1-x}Sn_x$Te, the value of x can be as high as 0.35, which is 35 atomic percent Sn. In a lead-salt system, $BaF_2$ provides a good insulating material for forming insulative substrate 20. It has a good lattice match, within approximately 4%, to PbTe and has a similar coefficient of thermal expansion.

Another suitable materials system which can be used to fabricate the present invention is based on $Bi_{1-x}Sb_y$ alloys. Others have studied extensively the quantum-mechanical tunnelling effect in these alloys. The element bismuth is a semi-metal which can be viewed generally as having three energy bands: a conduction band Ls, a valence band La and a heavy valence band T which can be described generally as a valence band with a large effective mass. The presence of the heavy valence band makes bismuth a semi-metal. By alloying bismuth with antimony, the heavy valence band T can be made to drop below the energy of the conduction band Ls. This creates a band gap which transforms the material into a useful semiconductor for practising the present invention. In Figure 8 of the drawings, the effect of adding Sb to Bi in terms of band energies is illustrated. Band energy is indicated by the vertical axis. Along the X axis, antimony is added by atomic percent. The convergence of the La band and Ls band can be seen at 5 atomic percent, and at 15 atomic percent the T band drops below the Ls band. $Bi_{1-x}Sb_x$ alloys can be made which have an extremely small effective mass, approaching 0.0 $m_o$, such as 0.01 $m_o$ . Preferred $Bi_{1-x}Sb_x$ alloys for use in forming tunnelling barrier 30 are those in the range of 10 atomic percent to 30 atomic percent antimony. That is, $Bi_{1-x}Sb_x$ alloys where x is in the range of from about 0.08 to about 0.3. This would give an effective mass of from about 0.0011 $m_o$ to 0.064 $m_o$ for electrons. In a $Bi_{1-x}SB_x$ materials system, mica serves as a useful material for insulative substrate 20. Bismuth alloys can be grown readily on mica and the two materials have roughly similar lattice constants and thermal characteristics.

In general, it is preferable to have a conduction effective mass for tunnelling barrier 30 in the range of about 0.01 $m_o$ to about 0.10 $m_o$ and most

preferably 0.02 $m_o$. It should be noted that these values of effective mass are those perpendicular to the [111] direction through the barrier crystal and the tunnelling transistors disclosed herein are preferably fabricated so that the tunnelling current flows perpendicular to the [111] direction. Of course, all layers are epitaxial layers. The free electron mass $m_o$ is $0.911 \times 10^{-27}$g. PbTe, PbSe, $Bi_{1-x}$ Sb and certain other materials have small effective hole masses as well as small effective electron masses. This property makes these materials potentially useful for fabricating tunnelling transistors in accordance with the present invention wherein the mobile charge carriers are holes rather than electrons. Both types of tunnelling transistor are fully intended to be within the scope of the present invention.

In Figure 9, another embodiment of the present invention is illustrated which is realized in a bismuth materials system. Injector layer 40 is bismuth which is patterned such that it partially overlies tunnelling barrier 42. Tunnelling barrier 42 is comprised of a $Bi_{1-x}Sb_x$ alloy, in this example $Bi_{.85}Sb_{.15}$, which has a higher band gap than bismuth and an effective electron mass of 0.003 $m_o$. In this embodiment, contact regions 44 and 46 are films of bismuth patterned such that they provide a space in which channel 48 can be formed. Contact regions 44 and 46 and channel 48 are all formed on an insulative substrate 50, which in this example could be mica. Since tunnelling barrier 42 is a high band gap material with respect to bismuth, it may overlap contact regions 44 and 46 without providing a path for electronic conduction between injector layer 40 and contact regions 44 and 46. All layers could be grown by molecular beam epitaxy or by metal-organic chemical vapour deposition, however, other techniques may be suitable. Metal contacts (not shown) could be formed on injector layer 40 and contact regions 44 and 46.

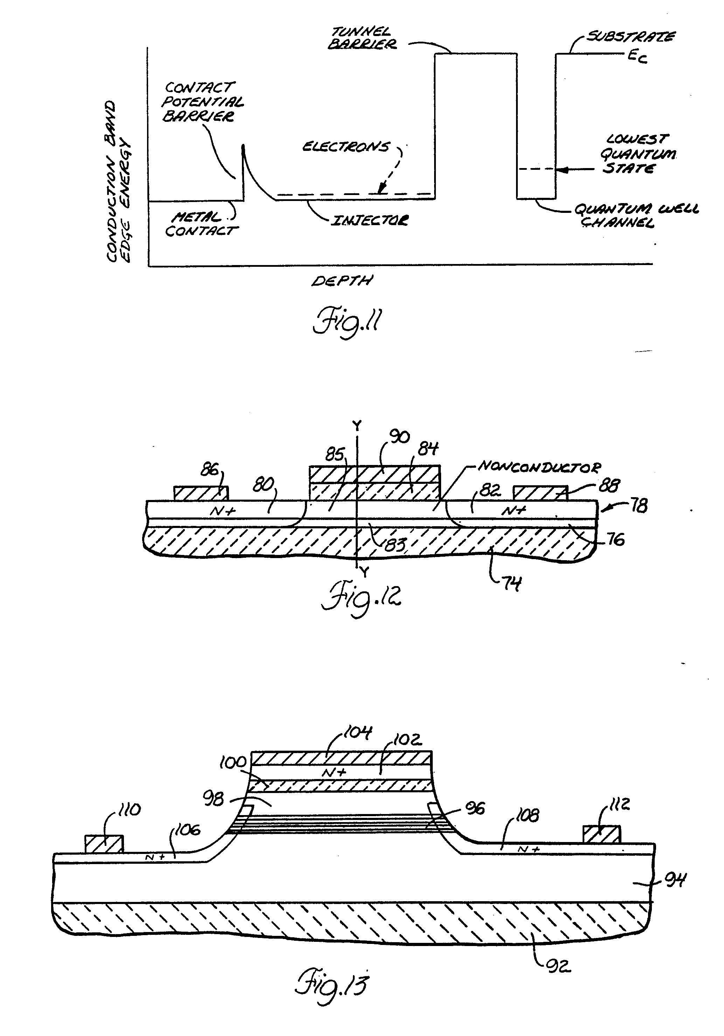

In Figure 10, another embodiment of our invention is shown having an electrically insulating, or high resistivity semiconductor, buffer layer 52 disposed between nearly intrinsic semiconductive film 54 and substrate 56. Buffer layer 52 provides a transition region between substrate 56 and channel 58 which reduces discontinuities which might otherwise be encountered if channel 58 is formed directly on substrate 56. In this embodiment, since buffer layer 52 is at least of very high resistivity, substrate 56 could even be conductive, if desired for some reason. Metal contact 60 is shown overlying injector layer 62 and in registration therewith. Here the injector layer material is heavily n-type PbTe which provides a good source of electrons as majority carriers for channel 58. It should be pointed out that in all of the embodiments, the tunnelling threshold can be controlled by changing the composition of the injector layer material. Generally, the fermi energy of the injector layer 62 should be high so that it is electrically conductive. This can be achieved in a semiconductor material most easily by doping the material to render it moderately heavily doped or degenerate. Alternatively, a material having an intrinsically high fermi energy such as a semi-metal or a metal can be used to form injector layer 62.

Tunnelling barrier 64 is made of high resistivity PbSrCaTe which is tailored to provide a material having a high band gap with respect to channel 58 and injector layer 62 and a low effective mass. It may be possible to lower the carrier concentration in tunnelling barrier 64 by the addition of small amounts of Yb, Sm or Tm to the barrier material.

In general, a small effective mass in the channel region of our invention is associated with high carrier mobility $\mu$ since:

$$\mu = e \, \frac{S}{m^*}$$

where e is the magnitude of the electronic charge of the carrier, S is the relaxation time or "mean free time between collisions" and $m^*$ is again the effective mass of the carrier. It is therefore desirable to decrease when possible the effective mass of carriers in the channel so that the relaxation time S is increased which increases carrier mobility and the mutual transconductance of the tunnelling transistor.

Referring again to Figure 10, contact regions 66 and 68 are formed in semiconductive film 54 by significantly doping these contact regions n-type through ion implantation or other suitable methods. It is not necessary that contact regions 66 and 68 extend into buffer layer 52 but may inherently occur during the implant or diffusion process. Channel 58 is at least nearly intrinsic PbTe material. Here a high resistivity PbTe substrate 56 is used. Metal contacts 70 and 72 are seen disposed, respectively, on contact regions 66 and 68 and on injector layer 62. Other materials systems for use herein may be suitable such as InSb, InAs and GaSb and, referring to the periodic table of the elements, generally Column III-Column V compounds. It may also be possible to use Column II-Column VI compounds in a HgCdTe system. These systems might also display fast transistor action because of low dielectric constants which lead to a smaller parasitic capacitances.

The tunnelling threshold of the present invention may also be controlled by constructing a tunnelling device having a channel which exhibits the quantum size effect. A quantum well is an ultra-thin layer of semiconductor material having a low band gap disposed between two layers of higher band gap material. Multiple quantum wells, also known as "superlattice", are formed by alternating layers of high band gap material with low band gap material. As stated, the tunnelling threshold of the present invention can be controlled by selecting a material having a particular band gap for the channel. The same effect can be achieved by thinning the channel so that the quantum size effect is the dominant characteristic of the carriers in the channel. In essence, by utilizing one or more quantum wells to form the channel, an "artificial" semiconductor region or "quantum channel" can be fabricated having a precise lowest energy state. In other words, through the use of quantum wells, a channel with the desired energy characteristics can be easily fabricated. The energy band diagram for the conduction band edge of that embodiment of the present invention which includes a single quantum well is shown in Figure 11. The X axis is in the direction of the reverse tunnelling current from the quantum channel through the tunnelling barrier into the injector layer.

Referring now to Figure 12, a tunnelling transistor having a quantum well constructed in accordance with the present invention is shown having a high band gap, high resistivity, substrate 74 on which a thin epitaxial layer of low band gap, high resistivity semiconductive material, referred to herein as quantum channel layer 76, is disposed thereon. Overlying quantum channel layer 76 is an epitaxial layer of high band gap, high resistivity semiconductive material, referred to herein as tunnel barrier layer 78. It can extend over the entire length of quantum channel layer 76. In order to achieve quantum size effects, quantum channel layer 76 should be between about 20 and about 1000 angstroms thick, depending on the desired lowest quantum state and material charateristics. Contact regions 80 and 82 are formed in tunnel barrier layer 78 and extend through quantum channel layer 76 to substrate 74. Contact regions 80 and 82 may be formed by doping these contact regions heavily by diffusion or ion implantation techniques. Contact regions 80 and 82 are separated by the residual high resistivity portion 83 of quantum channel layer 76 and the residual high resistivity portion 85 of tunnel barrier layer 78. An injector layer 84 is formed on the surface of residual high resistivity portion 85 of tunnel barrier layer 78. Since injector layer 84 is at least of fairly low electrical resistivity, it is configured to be inboard of contact regions 80 and 82. Otherwise it would provide an electrical short over residual high resistivity portion 83. Metal contacts 86 and 88 are formed on contact regions 80 and 82 respectively, and metal contact 90 is disposed on injector layer 84. Any convenient technique is suitable for forming the metal contacts 86-90. Alternatively, quantum channel layer 76 could comprise a superlattice (not shown) having multiple quantum wells.

In still another embodiment of the present invention depicted in Figure 13, a superlattice structure is used to grade the interface between a buffer layer and a channel to achieve a "stair-stepped" energy profile through which charge carriers move between contact regions. In a PbTe materials system, for example, substrate 92 is shown having an overlying high resistivity epitaxial buffer layer 94 of $Pb_{.8}Eu_{.2}Se_{.2}Te_{.8}$. Disposed over high resistivity buffer layer 94 is a superlattice 96 of atomic-layer thin regions of $Pb_{.8}Eu_{.2}Se_{.2}Te_{.8}$ alternating with atomic-layer thin regions of $Pb_{.95}Eu_{.05}Se_{.05}Te_{.95}$. For present purposes, each such region should be from about 10 angstroms to about 100 angstroms thick with, for example, from about 5 to about 100 alternating layers comprising superlattice 96. The top layer of superlattice 96 would in this instance be $Pb_{.8}Eu_{.2}Se_{.2}Te_{.8}$ and the bottom layer would be $Pb_{.95}Eu_{.05}Se_{.05}Te_{.95}$.

Disposed on superlattice 96 is epitaxial channel 98 comprised of $Pb_{.95}Eu_{.05}Se_{.05}Te_{.95}$. It should be noted here that the fabrication techniques used to form buffer layer 94, superlattice 96 and channel 98 resulted in very lightly-doped p-type material. However, these layers can suitably be intrinsic material. It should also be noted here that superlattice 96 does not function as the device channel in this embodiment of the present invention as it would in connection with the previously described embodiment. Overlying channel 98 is a tunnelling barrier 100 formed here of $Pb_{.8}Eu_{.2}Se_{.2}Te_{.8}$ and having a heavily doped n-type PbTe injector layer 102 disposed thereon. A metal contact 104 is formed on injector layer 102 using conventional metallization techniques.

In this embodiment of the present invention, contact regions 106 and 108 are disposed in and extend across buffer layer 94. Contact regions are also defined in and extend across the ends of superlattice 96 and slightly into channel 98. Using conventional fabrication techniques, contact regions 106 and 108 will most likely extend further upwardly, crossing into the opposite ends of tunnelling barrier 100 and injector layer 102, although this is not necessary to form a satisfactory device. A first metal contact 110 and a second metal contact 112 are formed on contact regions 106 and 108 respectively. Contact regions 106 and 108 may be formed by ion implantation or diffusion techniques.

In operation, a first electrical voltage is used to establish a potential across contact regions 106 and 108 and a second electrical voltage is used to bias injector layer 102. When injector layer 102 is biased approximately to reach the tunnelling threshold, carriers tunnel through tunnelling barrier 100 into channel 98, thereby lowering the channel resistance. Current then flows through channel 98 between contact regions 106 and 108. Superlattice 96 allows current to flow more easily through contact regions 106 and 108 across superlattice 96 where there would otherwise be a large energy gap at the interface of buffer layer 94 and channel 98. In effect, the superlattice 96 "grades" the energy transition between buffer layer 94 and channel 98.

## Claims

1. A tunnelling transistor comprising:
an electrically insulative substrate (20); a film (22) of semiconductor material disposed on the insulative substrate; and first and second spaced apart semiconductor regions (24,26) disposed in the semiconductor film; characterised by a third semiconductor region (28) disposed in the semiconductor film and interposed between the first and second semiconductor regions; and tunnelling means (30,32,38) contiguous with the third semiconductor region for quantum-mechanically moving charge carriers into and out of the third semiconductor region to change the electrical resistance of the third semiconductor region so that an electric current flowing through the third semiconductor region between the first and second semiconductor regions is modulated.

2. A tunnelling transistor as claimed in Claim 1, wherein the tunnelling means includes a tunnelling barrier (30) of semiconductor material disposed on the third semiconductor region (28) through which charge carriers tunnel quantum-mechanically, the tunnelling barrier having a band gap larger than that of the third semiconductor region.

3. A tunnelling transistor as claimed in Claim 2, wherein the tunnelling means further includes an injector layer (32) of electrically conductive material disposed on the tunnelling barrier (30), the injector layer having a band gap lower than that of the tunnelling barrier.

4. A tunnelling transistor as claimed in any one of Claims 2 to 3, wherein the tunnelling barrier (30) is formed of narrow band gap semiconductor material and has a conductivity effective mass less than 0.2 m $_o$, where $m_o$ is the free electron mass.

5. A tunnelling transistor as claimed in any one of Claims 1 to 4, further comprising a buffer layer (52) of semiconductor material disposed between and adjacent the insulative substrate (20) and the semiconductor film (22) for reducing crystal discontinuities which may otherwise occur at the interface of the insulative substrate and the semiconductor film.

6. A tunnelling transistor as claimed in any one of Claims 3 to 5, wherein the first and second semiconductor regions (24,26) have a first conductivity type; the third semiconductor region (28) has a second conductivity type; the tunnelling barrier (30) overlies the third semiconductor region, and partially overlies the first and second semiconductor regions; the tunnelling transistor further comprising first contact means (34,36) for applying an electrical potential across the first and second semiconductor regions; and, second contact means (38) for applying a first electrical potential across the injector layer (32) such that majority charge carriers in the injector layer tunnel quantum-mechanically through the tunnelling barrier into the third semiconductor region, to lower the electrical resistance of the third semiconductor region and cause an electrical current to flow between the first semiconductor region and the second semiconductor region through the third semiconductor region, and for applying a second electrical potential across the injector layer such that majority carriers in the third semiconductor region tunnel quantum-mechanically through the tunnelling barrier into the injector layer, to raise the electrical resistance of the third semiconductor region and terminate the current flowing between the first and second semiconductor regions.

7. A tunnelling transistor as claimed in claim 6, wherein the first conductivity type is n-type and the second conductivity type is selected from the group consisting of intrinsic, lightly p-type and lightly n-type materials.

8. A tunnelling transistor as claimed in claim 6 or claim 7, wherein the injector layer (32) includes material selected from the group consisting of metal, semi-metal and doped semiconductor.

9. A tunnelling transistor as claimed in any one of claims 6 to 8, wherein the first contact means includes first and second metal contacts (34,36) disposed respectively on the first and second semiconductor regions (24,26) and the second contact means includes a third metal contact (38) disposed on the injector layer (32).

10. A tunnelling transistor as claimed in any one of claims 6 to 9, wherein the insulative substrate (20) includes barium fluoride and the semiconductor film (22) includes PbTe.

11. A tunnelling transistor as claimed in any one of claims 6 to 10, wherein the injector layer (32) includes heavily doped n-type PbTe and the tunnelling barrier (30) layer is formed of material selected from the group consisting of a lead-chalcogenide alloy, CdTe, and a CdTe superlattice.

12. A tunnelling transistor as claimed in any one of claims 6 to 11, wherein the third semiconductor region (28) is from about 200 angstroms to about 10000 angstroms thick, the tunnelling barrier (30) is from about 20 angstroms to about 1000 angstroms thick, and the injector layer (32) is from about 1000 angstroms to about 20000 angstroms thick.

13. A tunnelling transistor as claimed in any one of claims 6 to 12, wherein the tunnelling barrier (30) has an effective mass of from about 0.2 $m_0$ to about 0.001 $m_0$ and an energy band gap of from about 1.5 ev to about 0.2 ev.

14. A tunnelling transistor as claimed in claim 3, wherein the insulative substrate (20) includes mica, the injector layer (32) includes bismuth, the tunnelling barrier (30) includes a first alloy of bismuth and antimony, and the third semiconductor region (28) includes a second alloy of bismuth and antimony.

15. A tunnelling transistor as claimed in any one of claims 5 to 13 comprising a superlattice (96) epitaxially interposed between the buffer layer (94) and the third semiconductor region (98) and in contact therewith, the superlattice comprising alternating epitaxial layers of the semiconductor material of the buffer layer and the semiconductor material of the third semiconductor region; wherein the injector layer is of material having a high fermi energy with respect to semiconductor materials of the buffer layer, the third semiconductor region, and the tunnelling barrier (100); the first and second semiconductor regions (106,108) being formed in the buffer layer and extending across the superlattice and into the third semiconductor region such that an electrical current flowing through the third semiconductor region between the first and second semiconductor regions passes through said superlattice.

16. A tunnelling semiconductor device comprising: a substrate (20) of electrically insulative material; a film (22) of low band gap semiconductor material disposed on the insulative substrate; first and second spaced apart semiconductor regions (24,26) disposed in the semiconductive film, the first and second semiconductor regions having a selected conductivity type; a third semiconductor region (28) disposed in the semiconductor film and interposed between the first and second semiconductor regions; a tunnelling barrier (30) of semiconductor material disposed on the semiconductive film and overlying the third semiconductor region, the tunnelling barrier having an energy band gap higher than that of the third semiconductor region; an injector layer (32) of semiconductor material disposed on the tunnelling barrier, the injector layer having a fermi energy within the conduction band; first contact means (34,36) for applying an electrical potential across the first and second semiconductor regions; and second contact means for electrically biasing the injector layer such that majority charge carriers in the injector layer tunnel through the tunnelling barrier into the third semiconductor region; to lower the electrical resistance of the third semiconductor region such that an electrical current flows between the first semiconductor region and the second semiconductor region through the third semiconductor region and for electrically biasing the injector layer such that majority carriers in the third semiconductor region tunnel through the tunnelling barrier into the injector layer, to raise the electrical resistance of the third semiconductor region and terminate the current flowing between the first and second semiconductor regions.

17. A tunnelling semiconductor device as claimed in Claim 16 wherein a buffer layer (52) of semiconductive material is disposed between the insulative substrate (56) and the semiconductor film (54).

Fig.1

Fig.2

Fig.3

Fig.4

Fig.5

Fig.6

Fig.7

Fig.8

Fig.9

- BISMUTH
40
42
48
BISMUTH
44
BISMUTH
46
50
NEARLY INTRISIC

Fig.10

60
70
62
58
66
NEARLY INTRINSIC
72
N+
64
68
N+
N+
54
HIGH RESISTIVITY BUFFER LAYER
52
56

*Fig.11*

*Fig.12*

*Fig.13*